# EUROPEAN PATENT SPECIFICATION

(11) **EP 1 958 025 B1**
(45) Date of publication and mention of the grant of the patent: **18.05.2011**
(21) Application number: 06838905.5
(22) Date of filing: 30.11.2006
(51) Int. Cl.: G03F 7/00

(54) **METHOD FOR EXPELLING GAS POSITIONED BETWEEN A SUBSTRATE AND A MOLD**
VERFAHREN ZUM AUSSTOSSEN VON ZWISCHEN EINEM SUBSTRAT UND EINER FORM BEFINDLICHEN GAS
PROCÉDÉ PERMETTANT D'EXPULSER UN GAZ POSITIONNÉ ENTRE UN SUBSTRAT ET UN MOULE

(30) Priority: 08.12.2005 US 748380 P; 27.03.2006 US 389731
(43) Date of publication of application: 20.08.2008
(73) Proprietor: MOLECULAR IMPRINTS, INC., Austin, TX 78758-3605 (US)
(72) Inventor: CHOI, Byung-jin, Austin, TX 78750 (US); SREENIVASAN, Sidlgata, V., Austin, TX 78750 (US); MCMACKIN, Ian, M., Austin, TX 78731 (US); LAD, Pankaj, B., DeSoto, TX 78115 (US)
(74) Representative: Ponzellini, Gianmarco
(86) International application number: PCT/US2006/046195
(87) International publication number: WO 2007/067469

(56) References cited:
- EP-A- 1 072 954
- WO-A-01/33300
- WO-A-2004/044651
- WO-A-2005/019934
- WO-A1-97/05608
- US-A- 5 234 717
- US-A1- 2002 093 122
- US-A1- 2003 092 261
- US-A1- 2004 090 611
- US-A1- 2004 197 712
- US-A1- 2005 024 609
- US-A1- 2005 072 755
- US-A1- 2006 268 256

## Description

### TECHNICAL FIELD

The field of the invention relates generally to nano-fabrication of structures. More particularly, the present invention is directed to a method and a system of expelling gas positioned between a substrate and a mold.

### BACKGROUND INFORMATION

Nano-fabrication involves the fabrication of very small structures, e.g., having features on the order of nanometers or smaller. One area in which nano-fabrication has had a sizeable impact is in the processing of integrated circuits. As the semiconductor processing industry continues to strive for larger production yields while increasing the circuits per unit area formed on a substrate, nano-fabrication becomes increasingly important. Nano-fabrication provides greater process control while allowing increased reduction of the minimum feature dimension of the structures formed. Other areas of development in which nano-fabrication has been employed include biotechnology, optical technology, mechanical systems and the like.

An exemplary nano-fabrication technique is commonly referred to as imprint lithography. Exemplary imprint lithography processes are described in detail in numerous publications, such as United States Patent Application publication 2004/0065976 filed as United States Patent Application 10/264,960, entitled, "Method and a Mold to Arrange Features on a Substrate to Replicate Features having Minimal Dimensional Variability"; United States Patent Application publication 2004/0065252 filed as United States Patent Application 10/264,926, entitled "Method of Forming a Layer on a Substrate to Facilitate Fabrication of Metrology Standards"; and United States Patent no. 6,936,194, entitled "Functional Patterning Material for Imprint Lithography Processes," all of which are assigned to the assignee of the present invention.

The fundamental imprint lithography technique disclosed in each of the aforementioned United States patent application publications and United States patent includes formation of a relief pattern in a polymerizable layer and transferring a pattern corresponding to the relief pattern into an underlying substrate. The substrate may be positioned upon a motion stage to obtain a desired position to facilitate patterning thereof. To that end, a template is employed spaced-apart from the substrate with a formable liquid present between the template and the substrate. The liquid is solidified to form a solidified layer that has a pattern recorded therein that is conforming to a shape of the surface of the template in contact with the liquid. The template is then separated from the solidified layer such that the template and the substrate are spaced-apart. The substrate and the solidified layer are then subjected to processes to transfer, into the substrate, a relief image that corresponds to the pattern in the solidified layer.

To that end, gases may be present between the template and the substrate and within the formable liquid which may result in, *inter alia,* pattern distortion of the solidified layer, low fidelity of features formed in the solidified layer, and a non-uniform thickness of a residual layer of the solidified layer, all of which are undesirable. To that end, a need exists, therefore, to provide a method and a system to expel gas positioned between a substrate and a mold.
EP 1 072 954 shows a substantially flexible mold which is brought into contact with energy-curable material with incremental contact either from the middle of the mold moving outward or from one side of the mold to the other.
WO 2005/019934 relates to a method of producing a pattern of projections on the surface of a substrate using a flexible mold that has a pattern of grooves corresponding to the pattern of projections to be formed on the surface of the substrate. A laminate roll is moved over the mold and pressure is applied onto the mold progressively from one edge to the other spreading a paste and filling the grooves of the mold.
US2004/0197712 discloses an inflatable stamp which is moved towards a substrate until it makes contact at a single point. The curvature of the stamp ensures that air is forced out before the two surfaces come into full contact.
WO97050608 shows a method of making an optical information record. A substrate having a surface for carrying an information bearing layer is provided. A curable polymer is provided on said surface of the substrate. A flexible stamper is distorted such that the inner region of the first surface bearing the information pattern bulges outward relative to the outer region, providing the first surface with a generally convex contour in at least one direction. The distorted stamper is positioned relative to the substance such that the convex surface of the stamper having the information bearing pattern is capable of being pressed against the surface of the substrate bearing the curable polymer on the substrate. The distorted first surface of the stamper and the polymer bearing surface of the substrate are pressed together, causing the inner region of the stamper to fist contact the substrate surface and the remainder of the distorted stamper to progressively contact the remainder of the stamper surface as the respective surfaces are further pressed together, thereby distributing the polymer across the substrate surface and forming a replica of the information bearing pattern in the polymer surface.
A method according to the present invention is disclosed in any one of the claims.

### BRIEF DESCRIPTION OF THE DRAWINGS

Fig. 1 is a simplified side view of a lithographic system having a template spaced-apart from a substrate, the template being coupled to a template chuck;

Fig. 2 is a top down view showing an array of droplets of imprinting material positioned upon a region of the substrate shown in Fig. 1;

Fig. 3 is a simplified side view of the substrate shown in Fig. 1, having a patterned layer positioned thereon;

Fig. 4 is a side view of the template and the template chuck, both shown in Fig. 1;

Fig. 5 is a bottom-up plan view of the template chuck shown in Fig. 4;

Fig. 6 is a flow diagram showing a method of patterning a region of the substrate shown in Fig. 1, in a first embodiment;

Fig. 7 is a side view of a mold coupled to the template shown in Fig. 1, with a shape of the mold and the template being altered;

Fig. 8 is a side view of the mold shown in Fig. 7, in contact with a portion of the droplets of imprinting material shown in Fig. 2;

Figs. 9-11 are top down views showing the compression of the droplets shown in Fig. 2, employing the altered shape of the template shown in Fig. 8;

Fig. 12 is a top down view showing the compression of the droplets shown in Fig. 2, employing the altered shape of the template shown in Fig. 8, in a further embodiment;

Fig. 13 is a flow diagram showing a method of patterning a region of the substrate shown in Fig. 1, in a second embodiment;

Fig. 14 is a side view of a mold coupled to the template shown in Fig. 1, spaced-apart from the substrate shown in Fig. 1;

Fig. 15 is a side view of the template and the template chuck, both shown in Fig. 1, in a further embodiment;

Fig. 16 is a bottom-up plan view of the template chuck shown in Fig. 15;

Fig. 17 is an exploded view of a region of the template chuck shown in Fig. 15;

Fig. 18 is a side view of a mold coupled to the template shown in Fig. 1, with a shape of the mold and the template being altered, according to a solution not part of the invention.

Fig. 19 is a side view of the substrate shown in Fig. 1, having a patterned layer positioned thereon having a substantially non-planar surface;

Fig. 20 is a side view of the substrate shown in Fig. 1, having a patterned layer positioned thereon having a substantially planar surface;

Fig. 21 is a side view of the template shown in Fig. 1, in contact with a patterned layer positioned on the substrate shown in Fig. 1, with the template substantially conforming to the patterned layer; and

Fig. 22 is a side view of the template shown in Fig. 1, in contact with a patterned layer positioned on the substrate shown in Fig. 1, with the patterned layer having a substantially planar surface.

### DETAILED DESCRIPTION

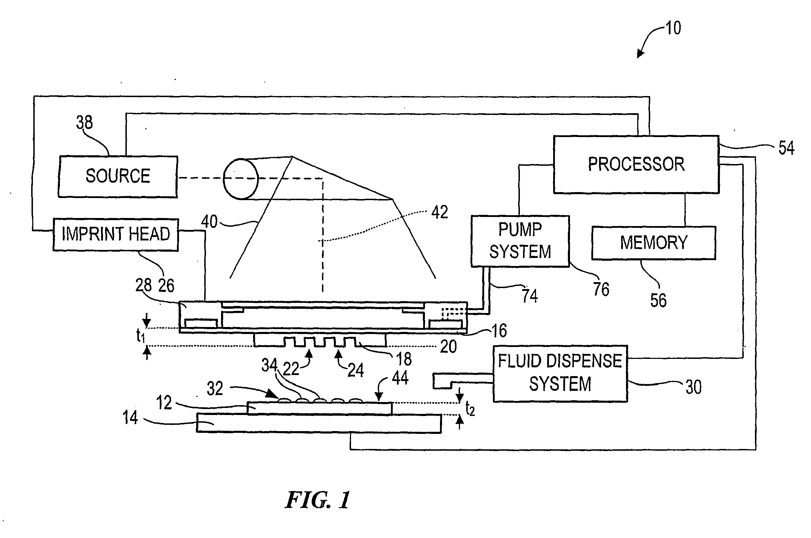

Referring to Fig. 1, a system 10 to form a relief pattern on a substrate 12 includes a stage 14 upon which substrate 12 is supported and a template 16. Template 16 may have a mesa 18 extending therefrom towards substrate 12 with a patterning surface 20 thereon. Further, mesa 18 may be referred to as a mold 18. In a further embodiment, template 16 may be substantially absent of mold 18. Furthermore, substrate 12 may be coupled to a substrate chuck (not shown), the substrate chuck (not shown) being any chuck including, but not limited to, vacuum and electromagnetic.

Template 16 and/or mold 18 may be formed from such materials including, but not limited to, fused-silica, quartz, silicon, organic polymers, siloxane polymers, borosilicate glass, fluorocarbon polymers, metal, and hardened sapphire. As shown, patterning surface 20 comprises features defined by a plurality of spaced-apart recesses 22 and protrusions 24. However, in a further embodiment, patterning surface 20 may be substantially smooth and/or planar. Patterning surface 20 may define an original pattern that forms the basis of a pattern to be formed on substrate 12.

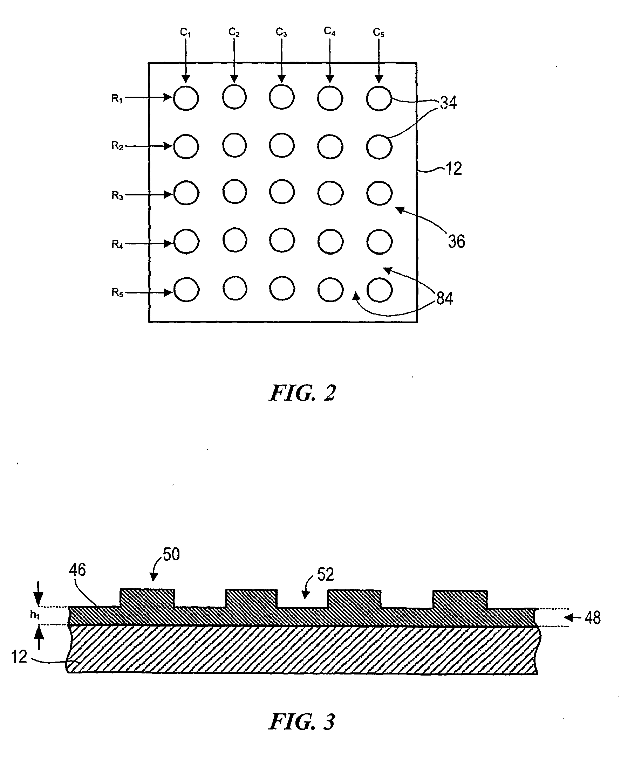

Template 16 may be coupled to a template chuck 28, template chuck 28 being any chuck including, but not limited to, vacuum and electromagnetic. Further, template chuck 28 may be coupled to an imprint head 26 to facilitate movement of template 16, and therefore, mold 18. A fluid dispense system 30 is coupled to be selectively placed in fluid communication with substrate 12, so as to deposit polymeric material 32 thereon. Fluid dispense system 30 may be comprised of a plurality of dispensing units therein. It should be understood that polymeric material 32 may be deposited using any known technique, e.g., drop dispense, spin-coating, dip coating, chemical vapor deposition (CVD), physical vapor deposition (PVD), thin film deposition, thick film deposition, and the like. As shown in Fig. 2, polymeric material 32 may be deposited upon substrate 12 as a plurality of spaced-apart droplets 34, defining a matrix array 36. In an example, each droplet of droplets 34 may have a unit volume of approximately 1-10 pico-liters. Droplets 34 of matrix array 36 may be arranged in five columns c₁-c₅ and five rows r₁-r₅. However, droplets 34 may be arranged in any two-dimensional arrangement on substrate 12.

An exemplary composition for polymeric material 32 is silicon-free and consists of the following:

### COMPOSITION 1

### isobornyl acrylate n-hexyl acrylate ethylene glycol diacrylate 2-hydroxy-2-methyl-1-phenyl-propan-1-one

To that end, COMPOSITION 1 may be described in United States patent 7,122,079 entitled "Composition for an Etching Mask Comprising a Silicon-Containing Material", which is incorporated by reference herein.

Referring to Fig. 1, to improve the release properties of mold 18 and polymeric material 32 and to ensure that polymeric material 32 does not adhere to mold 18, an additive may be included in COMPOSITION 1. To that end, polymeric material 32 may include, as an additive, a surfactant. For purposes of this invention a surfactant is defined as any molecule, one tail of which is hydrophobic. Surfactants may be either fluorine containing, e.g., include a fluorine chain, or may not include any fluorine in the surfactant molecule structure. An exemplary surfactant is available under the trade name ZONYL^{®} FSO-100 from DUPONT^{™} that has a general structure of R₁R₂ where R₁ = F(CF₂CF₂)_{Y}, with y being in a range of 1 to 7, inclusive and R₂ = CH₂CH₂O(CH₂CH₂O)_{X}H, where X is in a range of 0 to 15, inclusive. This provides polymeric material 24 with the following composition:

### COMPOSITION 2

### isobornyl acrylate n-hexyl acrylate ethylene glycol diacrylate 2-hydroxy-2-methyl-1-phenyl-propan-1-one R_{f}CH₂CH₂O(CH₂CH₂O)_{X}H,

In a further embodiment, exemplary compositions from which to form polymeric material 32 are as follows:

### COMPOSITION 3

### hydroxyl-functional polysiloxane hexamethoxymethylmelamine toluenesulfonic acid methyl amyl ketone

### COMPOSITION 4

### hydroxyl-functional polysiloxane hexamethoxymethylmelamine gamma-glycidoxypropyltrimethoxysilane toluenesulfonic acid methyl amyl ketone

To that end, COMPOSITIONS 2-4 may also be described in United States patent 7,122,079 entitled "Composition for an Etching Mask Comprising a Silicon-Containing Material."

Referring to Fig. 1, system 10 further comprises a source 38 of energy 40 coupled to direct energy 40 along a path 42. Imprint head 26 and stage 14 are configured to arrange mold 18 and substrate 12, respectively, to be in superimposition and disposed in path 42. Either imprint head 26, stage 14, or both vary a distance between mold 18 and substrate 12 to define a desired volume therebetween that is filled by polymeric material 32.

Referring to Figs. 1 and 3, typically, polymeric material 32 is disposed upon substrate 12 before the desired volume is defined between mold 18 and substrate 12. However, polymeric material 32 may fill the volume after the desired volume has been obtained. After the desired volume is filled with polymeric material 32, source 38 produces energy 40, e.g., broadband ultraviolet radiation that causes polymeric material 32 to solidify and/or cross-link conforming to the shape of a surface 44 of substrate 12 and patterning surface 20, defining a patterned layer 46 on substrate 12. In an example, energy 40 may have a wavelength in a range of approximately 240 - 420 nm. Patterned layer 46 may comprise a residual layer 48 and a plurality of features shown as protrusions 50 and recessions 52. Control of this process is regulated by a processor 54 that is in data communication with stage 14, imprint head 26, fluid dispense system 30, and source 38, operating on a computer readable program stored in memory 56.

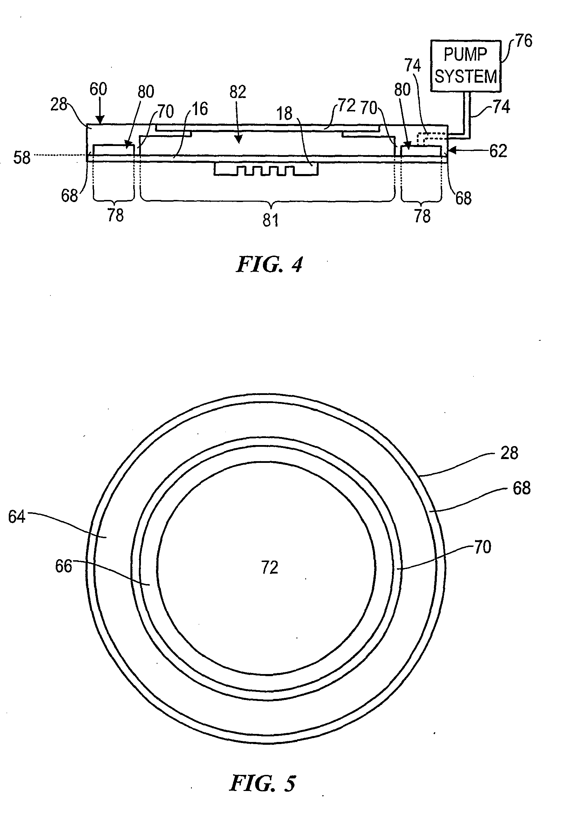

Referring to Figs. 4 and 5, template chuck 28 is adapted to retain template 16 upon which mold 18 is attached employing vacuum techniques. As shown, template chuck 28 comprises a substantially circular shape. However, in a further embodiment, template chuck 28 may comprise any geometric shape desired. Template chuck 28 includes first 58 and second 60 opposed sides. A side, or edge, surface 62 extends between first side 58 and second side 60. First side 58 includes a first recess 64 and a second recess 66, spaced-apart from first recess 64, defining first 68 and second 70 spaced-apart support regions. First support region 68 cinctures second support region 70 and first 64 and second 66 recesses. Second support region 70 cinctures second recess 66. In a further embodiment, first and second support regions 68 and 70 may be formed from a compliant material. A portion 72 of template chuck 28 in superimposition with second recess 66 may be transparent to radiation having a predetermined wavelength, such as the wavelength of the actinic radiation mentioned above. To that end, portion 72 may be made from a thin layer of transparent material, such as glass. However, the material from which portion 72 is made may depend upon the wavelength of radiation produced by source 38, shown in Fig.1. Portion 72 extends between second side 60 and terminates proximate to second recess 66 and should define an area at least as large as an area of mold 18 so that mold 18 is in superimposition therewith.

Formed in template chuck 28 is a throughway 74, however, template chuck 28 may comprise any number of throughways. Throughway 74 places first recess 64 in fluid communication with side surface 62, however, in a further embodiment, it should be understood that throughway 74 may place first recess 64 in fluid communication with any surface of template chuck 28. In still a further embodiment, template chuck 28 may comprise a throughway (not shown) placing second recess 66 in fluid communication with any surface of template chuck 28. Furthermore, what is desired is that throughway 74 facilitates placing first recess 64 in fluid communication with a pressure control system, such as a pump system 76.

Referring to Figs. 1,4 and 5, pump system 76 may include on or more pumps to control the pressure proximate to first recess 64. Specifically, when mounted to template chuck 28, template 18 rests against first 68 and second 70 support regions, covering first 64 and second 66 recesses. First recess 64 and a portion 78 of template 16 in superimposition therewith define a first chamber 80. Second recess 66 and a portion 81 of template 18 in superimposition therewith define a second chamber 82. Pump system 76 operates to control a pressure in first chamber 80. In a further embodiment, pump system 76 may control a pressure in second chamber 82. Specifically, the pressure is established in first chamber 80 to maintain the position of template 18 with template chuck 28 and reduce, if not avoid, separation of template 18 from template chuck 28 under force of gravity. Pump system 76 may be in data communication with processor 54, operating on computer readable program stored in memory 56 to control pump system 76.

Referring to Figs. 1, 2, and 3, as mentioned above, a distance between mold 18 and substrate 12 is varied such that a desired volume is defined therebetween that is filled by polymeric material 32. Furthermore, after solidification, polymeric material 32 conforms to the shape of surface 44 of substrate 12 and patterning surface 20, defining patterning layer 46 on substrate 12. To that end, in a volume 84 defined between droplets 34 of matrix array 36, there are gases present, and droplets 34 in matrix array 36 are spread over substrate 12 so as to avoid, if not prevent, trapping of gases and/or gas pockets between substrate 12 and mold 18 and within pattering layer 46. The gases and/or gas pockets may be such gases including, but not limited to air, nitrogen, carbon dioxide, and helium. Gas and/or gas pockets between substrate 12 and mold 18 and within patterning layer 46 may result in, *inter* alia, pattern distortion of features formed in patterning layer 46, low fidelity of features formed in patterning layer 46, and a non-uniform thickness of residual layer 48 across patterned layer 46, all of which are undesirable. To that end, a method and a system of minimizing, if not preventing, trapping of gas and/or gas pockets between substrate 12 and mold 18 and within patterning layer 46 are described below.

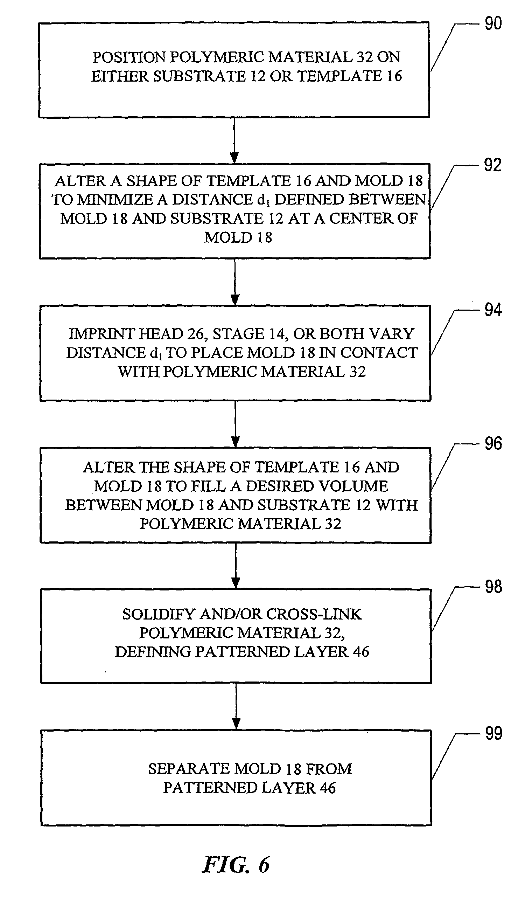

Referring to Figs. 1 and 6, in a first embodiment, a method of expelling gas between substrate 12 and mold 18 is shown. More specifically, at step 90, as mentioned above, polymeric material 32 may be positioned on substrate 12 by drop dispense, spin-coating, dip coating, chemical vapor deposition (CVD), physical vapor deposition (PVD), thin film deposition, thick film deposition, and the like. In a further embodiment, polymeric material 32 may be positioned on mold 18.

Referring to Figs. 4, 6 and 7, at step 92, a shape of template 16 and mold 18 may be altered such that a distance d₁ defined between mold 18 and substrate 12 at a center sub-portion of mold 18 is less than a distance defined between mold 18 and substrate 12 at remaining portions of mold 18. In an example, distance d₁ is less than a distance d₂, distance d₂ being defined at an edge of mold 18. In a further embodiment, the distance d₁ may be defined at any desired location of mold 18. The shape of template 16 and mold 18 may be altered by controlling a pressure within first chamber 80. More specifically, as mentioned above, pump system 76 operates to control the pressure in first chamber 80. To that end, pump system 76 may create a vacuum within first chamber 80 via throughway 74 such that portion 78 of template 18 may bow away from substrate 12 and bow towards template chuck 28. As a result of bowing portion 78 of template 18 away from substrate 12, portion 81 of template 18 bows toward substrate 12 and away from template chuck 28. In an example, the bowing of portion 81 of template 18 may be on the order of 50 µm over 100 mm.

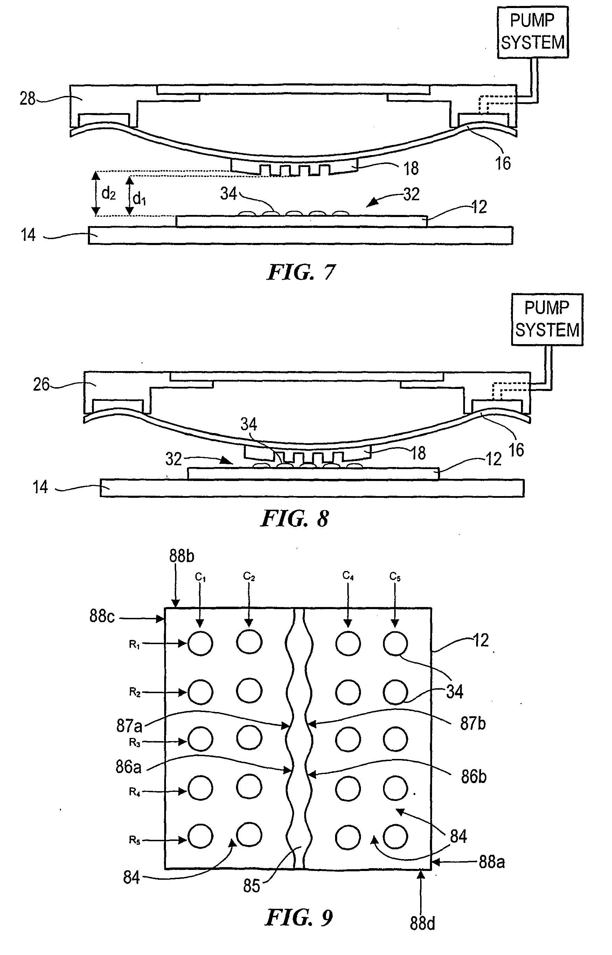

Referring to Figs. 6, 8, and 9, at step 94, as described above with respect to Fig. 1, either imprint head 26, shown in Fig. 1, stage 14, or both, may vary distance d₁, shown in Fig. 7, such that a sub-portion of mold 18 contacts a sub-portion of droplets 34. As shown, a center sub-portion of mold 18 contacts a sub-portion of droplets 34 prior to the remaining portions of mold 18 contacting the remaining droplets of droplets 34. However, in a further embodiment, any portion of mold 18 may contact droplets 34 prior to remaining portions of mold 18. To that end, as shown, mold 18 contacts all of droplets 34 associated with column c₃, shown in Fig. 2, substantially concurrently. This causes droplets 34 to spread and to produce a contiguous liquid sheet 85 of polymeric material 32. Edges 86a and 86b of liquid sheet 85 define liquid-gas interfaces 87a and 87b, respectively, that function to push gases in volume 84 toward edges 88a, 88b, 88c, and 88d. Volume 84 between droplets 34 in columns c₁-c₅ define gas passages through which gas may be pushed to edges 88a, 88b, 88c, and 88d. As a result, liquid-gas interfaces 87a and 87b in conjunction with the gas passages reduces, if not prevents, trapping of gases in liquid sheet 85.

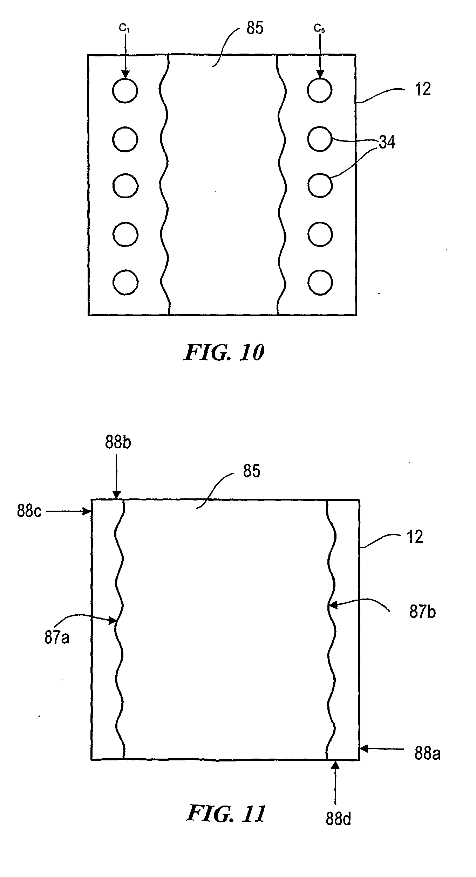

Referring to Figs. 4, 6, 8, and 10, at step 96, the shape of template 16 and mold 18 may be altered such that the desired volume defined between mold 18 and substrate 12 may be filled by polymeric material 32, as described above with respect to Fig. 1. More specifically, the shape of template 16 and mold 18 may be altered by the combination of controlling the pressure within first chamber 80 and a force exerted by imprint head 26, shown in Fig. 1, and/or stage 14 upon template 16 and mold 18 as a result of contact been polymeric material 32 and mold 18. More specifically, as mentioned above, pump system 76 operates to control the pressure in first chamber 80. To that end, pump system 76 decreases a magnitude of the vacuum created within first chamber 80 via throughway 74 such that polymeric material 32 associated with subsequent subsets of droplets 34 in columns c₂ and c₄, shown in Fig. 2, spread to become included in contiguous fluid sheet 85. The shape of template 16 and mold 18 continues to be altered such that mold 18 subsequently comes into contact with droplets 34 associated with columns c₁ and c₅ so that polymeric material 32 associated therewith spreads to become included in contiguous sheet 85, as shown in Fig. 11. As can be seen, interfaces 87a and 87b have moved towards edges 88a and 88c, respectively, so that there is an unimpeded path for the gases in the remaining volume 84, shown in Fig. 9, to travel thereto. This allows gases in volume 84, shown in Fig. 9, to egress from between mold 18 and substrate 12 vis-à-vis edges 88a, 88b, 88c and 88d. In this manner, the trapping of gas and/or gas pockets between substrate 12 and mold 18 and within patterning layer 46, shown in Fig. 3, is minimized, if not prevented. In a further embodiment, the shape of template 16 and mold 18 may be altered concurrently with decreasing the distance d₁, as mentioned above with respect to Fig. 8. Furthermore, it may be desired to balance a speed at which polymeric material 32 fills the desired volume between mold 18 and substrate 12. More specifically, if interfaces 87a and 87b propagate towards edges 88a and 88b too fast, pockets of gas may be created between mold 18 and substrate 12, which is undesirable. To that end, in an example, the shape of template 16 and mold 18 may be altered such that polymeric material 32 fills the desired volume between mold 18 and substrate 12 at a speed of 100 mm in a few seconds.

Referring to Fig. 6, at step 98, as mentioned above with respect to Fig. 1, polymeric material 32 may be then be solidified and/or cross-linked, defining patterned layer 46, shown in Fig. 3. Subsequently, at step 99, mold 18 may be separated from patterned layer 46, shown in Fig. 3.

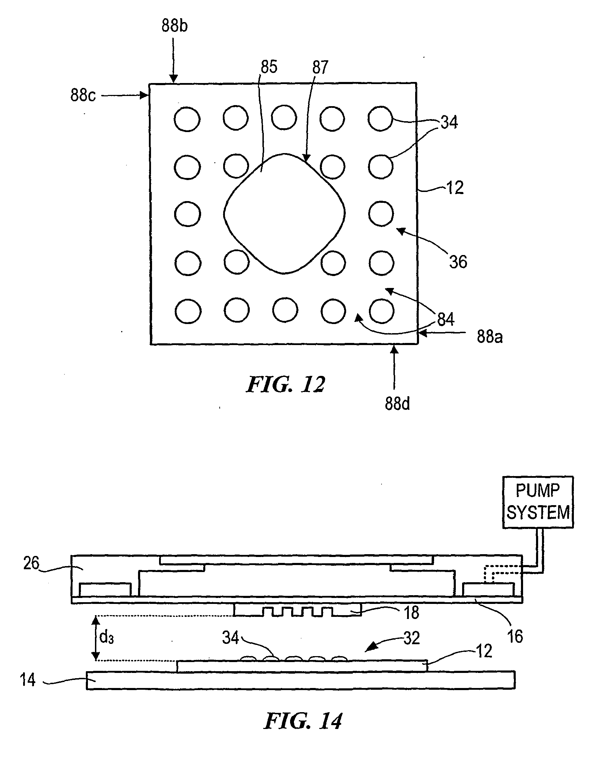

Referring to Figs. 4 and 12, as described above, the shape of template 16 and mold 18 may be altered along a first direction. However, in a further embodiment, the shape of template 16 and mold 18 may be altered concurrently in first and second directions, with the second direction extending orthogonal to the first direction. More specifically, template 16 and mold 18 may be altered such that a center sub-portion of mold 18 contacts a sub-portion of droplets 34 prior to the remaining portions of mold 18 contacting the remaining droplets of droplets 34, as described above with respect to Fig. 9. This causes droplets 34 to spread and to produce contiguous liquid sheet 85 of polymeric material 32, defining continuous liquid-gas interface 87 that functions to push gases in volume 84 outward radially. In an example, liquid sheet 85 may have a circular or circular-like expansion of liquid-gas interface 87 to push gases in volume 84 towards edges 88a, 88b, 88c, and 88d outward radially. However, in a further embodiment, the shape of template 16 and mold 18 may be altered to in any direction to produce liquid sheet 85 with any geometric shape desired to facilitate pushing gases in volume 84 towards edges 88a, 88b, 88c, and 88doutward radially to minimize, if not prevent, trapping of gas and/or gas pockets between substrate 12 and mold 18 and within patterning layer 46.

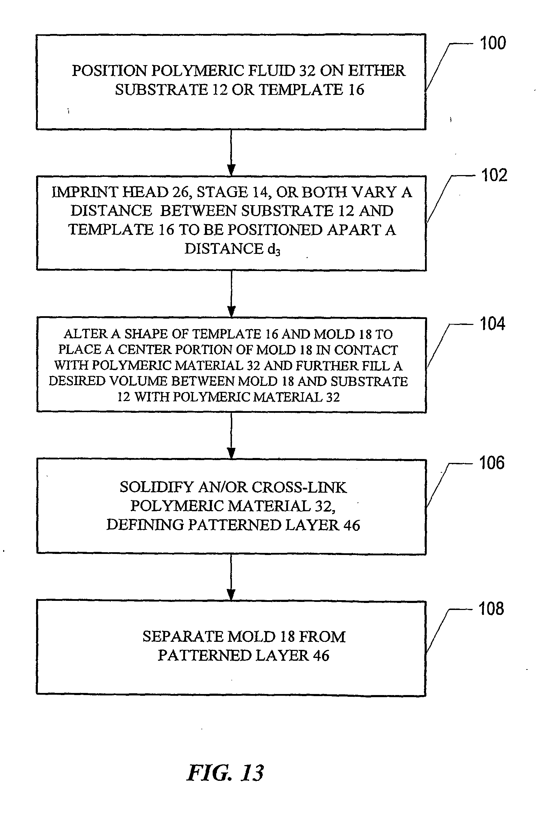

Referring to Fig. 13, a further embodiment of the present invention is shown. More specifically, at step 100, analogous to that mentioned above with respect to step 90 shown in Fig. 6, polymeric material 32 may be positioned on substrate 12 or mold 18.

Referring to Figs. 13 and 14, at step 102, mold 18 and substrate 12 are positioned such that a distance d₃ is defined therebetween. Imprint head 26, shown in Fig. 1, stage 14, or both may position mold 18 and substrate 12 to obtain distance d₃ between substrate 12 and mold 18. In a further embodiment, mold 18 may extend in a first plane and substrate 12 may extend in a second plane, with the first and second planes being substantially parallel. In an example, distance d₃ may have a magnitude in a range of 5-50 microns. Distance d₃ is defined such that upon altering the shape of template 16 and mold 18, a sub-portion of mold 18 contacts a sub-portion of droplets 34, described further below.

Referring to Figs. 8 and 13, at step 104, the shape of template 16 and mold 18 may be altered such that a center sub-portion of mold 18 contacts a sub-portion of droplets 34 prior to the remaining portions of mold 18 contacting the remaining droplets of droplets 34. However, in a further embodiment, any portion of mold 18 may contact droplets 34 prior to remaining portions of mold 18. To that end, analogous to that mentioned above with respect to Fig. 9, mold 18 contacts all of droplets 34 associated with column c₃, shown in Fig. 2, substantially concurrently. This causes droplets 34 to spread and to produce a contiguous liquid sheet 85 of polymeric material 32. Edges 86a and 86b of liquid sheet 85 define liquid-gas interfaces 87a and 87b, respectively, that function to push gases in volume 84 toward edges 88a, 88b, 88c, and 88d. Volume 84 between droplets 34 in columns c₁-c₅ define gas passages through which gas may be pushed to edges 88a, 88b, 88c, and 88d. As a result, liquid-gas interfaces 87a and 87b in conjunction with the gas passages reduces, if not prevents, trapping of gases in liquid sheet 85. ,

Furthermore, after contact of droplets 34 associated with column c₃ with mold 18, the shape of template 16 and mold 18 may be further altered such that the desired volume defined between mold 18 and substrate 12 may be filled by polymeric material 32, as described above with respect to Fig. 1. More specifically, analogous to that mentioned above with respect to Figs. 10-12, the shape of template 16 and mold 18 may be altered by the combination of controlling the pressure within first chamber 80 and a force exerted by imprint head 26 and/or stage 12 upon template 16 and mold 18 as a result of contact been polymeric material 32 and mold 18. More specifically, as mentioned above, pump system 76 operates to control the pressure in first chamber 80. To that end, pump system 76 decreases a magnitude of the vacuum created within first chamber 80 via throughway 74 such that polymeric material 32 associated with subsequent subsets of droplets 34 in columns c₂ and c₄, shown in Fig. 2, spread to become included in contiguous fluid sheet 85, as shown in Fig. 10. The shape of template 16 and mold 18 continues to be altered such that mold 18 subsequently comes into contact with droplets 34 associated with columns c₁ and c₅ so that polymeric material 32 associated therewith spreads to become included in liquid sheet 85, as shown in Fig. 11. As can be seen, interfaces 87a and 88b have moved towards edges 88a and 88b, respectively, so that there is an unimpeded path for the gases in the remaining volume 84, shown in Fig. 9, to travel thereto. This allows gases in volume 84, shown in Fig. 9, to egress from between mold 18 and substrate 12 vis-à-vis edges 88a, 88b, 88c, and 88d. In this manner, the trapping of gas and/or gas pockets between substrate 12 and mold 18 and within patterning layer 46, shown in Fig. 3, is minimized, if not prevented. In a further embodiment, the shape of template 16 and mold 18 may be altered concurrently with decreasing the distance d₁, as mentioned above with respect to Fig. 8.

Referring to Fig. 13, at step 106, as mentioned above with respect to Fig. 1, polymeric material 32 may be then be solidified and/or cross-linked, defining patterned layer 46, shown in Fig. 3. Subsequently, at step 108, mold 18 may be separated from patterned layer 46, shown in Fig. 3. In a further embodiment, substrate 12 may be subjected to the above-mentioned processes such that a shape of substrate 12 may be altered to minimize, if not prevent, trapping of gas and/or gas pockets between substrate 12 and mold 18 and within patterning layer 46. Furthermore, template 16, mold 18, and substrate 12 may be subjected to the above-mentioned processes concurrently.

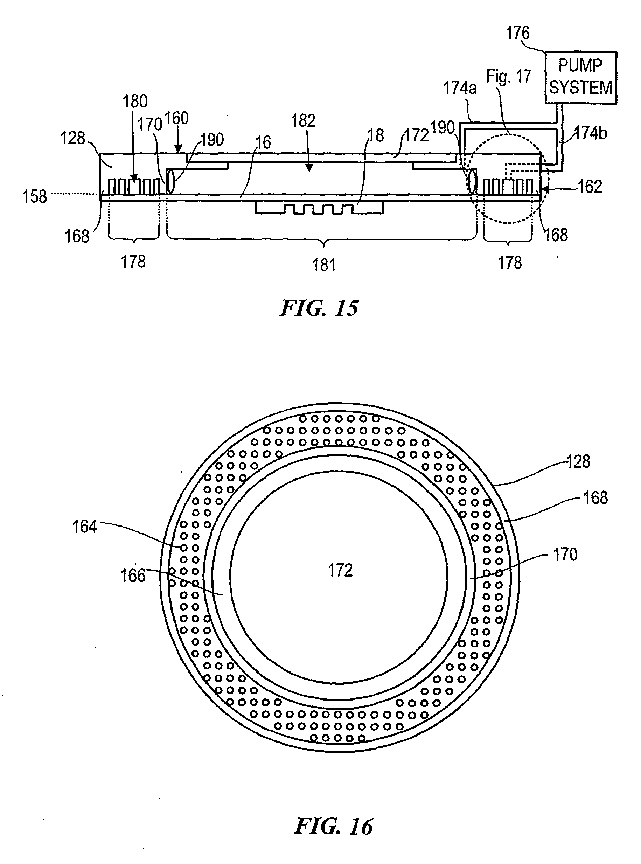

Referring to Figs. 15 and 16, a second embodiment of template chuck 28 is shown. More specifically, analogous to template chuck 28 mentioned above with respect to Fig. 4, template chuck 128 includes first 158 and second 160 opposed sides. A side, or edge, surface 162 extends between first side 158 and second side 160. As shown, template chuck 128 comprises a substantially circular shape. However, in a further embodiment, template chuck 128 may comprise any geometric shape desired. First side 158 includes a first recess 164 and a second recess 166, spaced-apart from first recess 164, defining first 168 and second 170 spaced-apart support regions. First support region 168 cinctures second support region 170 and the first 164 and second 166 recesses. Second support region 170 cinctures second recess 166. In a further embodiment, first and second support regions 168 and 170 may be formed from a compliant material. A portion 172 of template chuck 128 in superimposition with second recess 166 may be transparent to radiation having a predetermined wavelength, such as the wavelength of the actinic radiation mentioned above. To that end, portion 172 may be made from a thin layer of transparent material, such as glass. However, the material from which portion 172 is made may depend upon the wavelength of radiation production by source 38, shown in Fig.1. Portion 172 extends between second side 160 and terminates proximate to second recess 166 and should define an area at least as large as an area of mold 18 so that mold 18 is in superimposition therewith.

Referring to Figs. 15, 16, and 17, template chuck 128 further includes a plurality of pins 186 projecting from a nadir surface 188 of first recess 164. Pins 186 provide mechanical support for template 16 retained on template chuck 128 via vacuum. Pins 186 are typically rigid posts having a circular cross-section. However, in a further embodiment, pins 186 may have any geometric shape desired.

Referring to Fig. 15, formed in template chuck 128 are throughways 174a and 174b, however, template chuck 128 may comprise any number of throughways. Throughway 174a places first recess 164 in fluid communication with side surface 162, however, in a further embodiment, it should be understood that throughway 174a may place first recess 164 in fluid communication with any surface of template chuck 128. Throughway 174b places second recess 166 in fluid communication with second side 160, however, in a further embodiment, it should be understood that throughway 174b may place second recess 166 in fluid communication with any surface of template chuck 128. Furthermore, what is desired is that throughways 174a and 174b facilitates placing first recess 164 and second recess 166, respectively, in fluid communication with a pressure control system, such as a pump system 176.

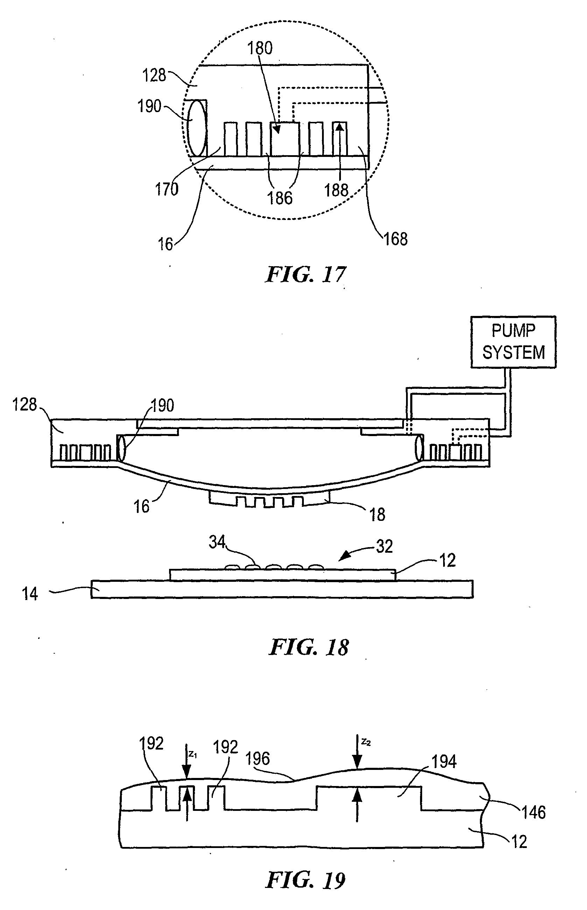

Referring to Figs. 15 and 16, pump system 176 may include on or more pumps to control the pressure proximate to first recess 164 and second recess 166. Specifically, when mounted to template chuck 128, template 16 rests against first 168 and second 170 support regions, covering first 164 and 166 recesses. First recess 164 and a portion 178 of template 116 in superimposition therewith define a first chamber 180. Second recess 166 and a portion 181 of template 16 in superimposition therewith define a second chamber 182. Pump system 176 operates to control a pressure in first and second chambers 180 and 182. Specifically, the pressure is established in first and second chambers 180 and 182 to maintain the position of template 16 with template chuck 128 and reduce, if not avoid, separation of template 16 from template chuck 128 under force of gravity. To that end, template chuck 128 further comprises compliant sealing 190 positioned adjacent second support region 170 to isolate first chamber 180 from second chamber 182 to facilitate obtaining a desired pressure and/or vacuum within first and second chambers 180 and 182. To that end, pump system 176 may create a pressure within second chamber 182 such that portion 181 of template 18 may bow towards substrate 12 and bow away from template chuck 128, as shown in Fig. 17. Template chuck 128 may then be employed in any of the methods mentioned above with respect to minimize, if not prevent the trapping of gas and/or gas pockets between substrate 12 and mold 18 and within patterning layer 46, shown in Fig. 3.

Referring to Figs. 1 and 3, furthermore, in addition to minimizing, if not preventing the trapping of gas and/or gas pockets between substrate 12 and mold 18 and within patterning layer 46, it may also be desired for residual layer 48 to be substantially uniform. More specifically, it may be desired for residual layer 48 to have a substantially uniform height h₁ defined across patterned layer 46. To that end, to obtain residual layer 48 having a substantially uniform height h₁, the desired volume defined between mold 18 and substrate 12 may be filled by capillary forces of polymeric material 32, as described in United States patent application publication 2005/0061773, filed as United States patent application 10/645,306, entitled "Capillary Imprinting Technique", which is incorporated by reference herein. More specifically, when the unit volume of each droplet of droplets 34 is controlled such that h₁ of residual layer 48 is in the range of a few nanometers to a few microns, each droplet of droplets 34 may spread to regions adjacent thereto in a few seconds or faster, and thus, height h₁ of residual layer may be substantially uniform over patterned layer 46.

A thickness t₁ of template 16 and mold 18 may further facilitate obtaining a substantially uniform height h₁ of residual layer 48. More specifically, the thickness t₁ of template 16 and mold 18 may have a magnitude such that a bending stiffness of template 16 and mold 18 may be balanced with the aforementioned capillary forces of polymeric material 32 to facilitate obtaining a substantially uniform height h₁ of residual layer 48. More specifically, the bending stiffness of template 16 and mold 18 is a cubic function thereof. To that end, were thickness t₁ too thick, thickness h₁ of residual layer 48 would be substantially non-uniform; however, were the thickness t₁ of template 16 and mold 18 too thin, a local defect among droplets 34, shown in Fig. 2, may result in a plurality of non-uniform localized perturbations in thickness h₁ of residual layer 48. Therefore, t₁ of template 16 and mold 18 may be in the range of 100µm-2mm in the presence of a few microns of out-of plane variation in template 16 and/or substrate 12.

The thickness t₁ of template 16 and mold 18 may have a magnitude such that variations among height h₁ of residual layer 48 due to surface non planarity of template 16 and mold 18 are minimized, if not prevented, while having a magnitude to minimize, if not prevent, producing local undesirable variations among height h₁ of residual layer 48 due to deformations of template 16 and mold 18 resulting from fluid pressure within first and second chambers 80 and 82, shown in Fig. 4. However, the magnitude of thickness t₁ should also facilitate the handling of template 16 and mold 18 by system 10 and separation thereof from patterned layer 46. In a further embodiment, a thickness t₂ of substrate 12 may have a magnitude in the manner described above with respect to thickness t₁ of template 16 and mold 18.

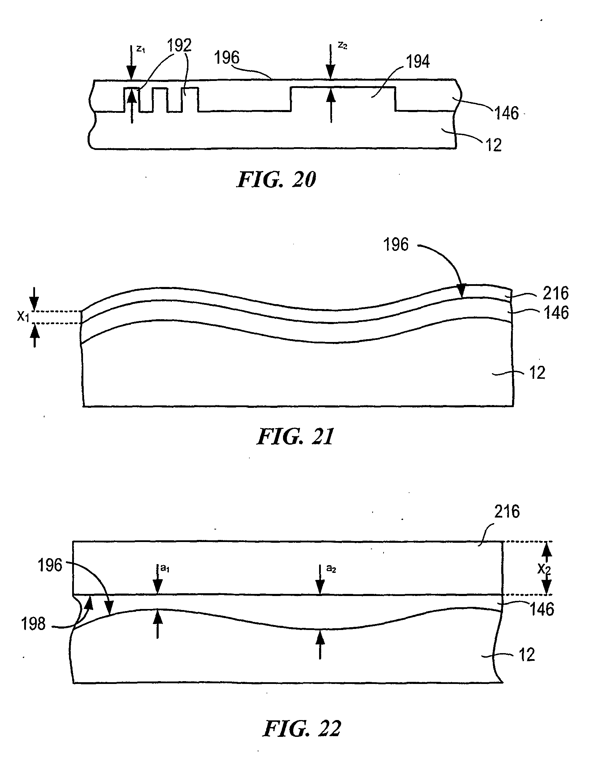

Referring to Figs. 1 and 19, substrate 12 is shown comprising protrusions 192 and protrusion 194. A thickness z₁ is defined between protrusion 192 and surface 196 of patterned layer 146 and a thickness z₂ is defined between protrusion 194 and surface 196. As shown, thickness z₂ is greater than z₁. This may result from positioning polymeric fluid 32 on substrate 12 by spin-coating, and thus, patterned layer 146 may tend to contour to the surface topology of substrate 12, resulting in local film thickness variations among patterned layer 146, which is undesirable. To that end, the methods mentioned above may be employed in planarization of polymeric fluid 32 on substrate 12 such that patterned layer 146 is substantially planar, as shown in Fig. 20. More specifically, employing template 16 and mold 18 having a bowed shape, as mentioned above, may facilitate patterned layer 146 having a substantially planar shape. To that end, as shown in Fig. 20, the thickness z₂ is substantially the same as the thickness z₁, which is desirable. In an example, protrusions 192 may be less than 200nm wide while protrusion 194 may be on the order of 50 microns-100 microns wide.

Referring to Fig. 21, to facilitate planarizing surface 196 of patterned layer 146, template 216 may be employed having a predetermined thickness such that upon contact with patterned layer 146 and/or substrate 12, template 216 may be non-conforming thereto. To that end, as shown, template 216 has a thickness x₁. However, thickness x₁ of template 216 facilitates template 216 conforming to patterned layer 146 in the presence of a long spatial waviness. Such a uniform layer may be used to form an etching mask to reverse the tone features, as described in United States patent application publication 2004/0188381, filed as United States paent application 10/396,615, entitled "Positive Tone Bi-Layer Imprint Lithography Method", which is incorporated by reference herein. To that end, template 216 may have a thickness x₂, as shown in Fig. 22, which does not conform to patterned layer 146 or substrate 12. A thickness a₁ defined between a surface 198 of template 216 and surface 196 of patterned layer 146 at a first location differs from a thickness a₂ defined between surface 198 and surface 196 at a second location, differing from the first location. As a result, surface 196 of patterned layer 146 is substantially planar. In an example, thickness x₂ of template 216 may be 6.25 mm.

The embodiments of the present invention described above are exemplary. Many changes and modifications may be made to the disclosure recited above, while remaining within the scope of the invention. Therefore, the scope of the invention should not be limited by the above description, but instead should be determined with reference to the appended claims.

## Claims

1. A method for expelling a gas positioned between a substrate (12) and a mold assembly (16, 18), said substrate and said mold assembly further having a liquid (32) positioned therebetween, said method comprising the steps of:
positioning (90) said mold assembly (16, 18) and said substrate (12) such that said mold assembly is proximate to said substrate, said mold assembly (16, 18) having a first region (78; 178) and a second region (81; 181);
altering (92) a shape of said mold assembly (16, 18) by bowing said first region (78; 178) away from said substrate such that said second region (81; 181) bows toward said substrate to decrease a gap defined between said second region (81; 181) of said mold assembly (16, 18) and said substrate (12); and
contacting (94) a sub-portion of said liquid with said second region (81; 181) of said mold assembly (16; 18) prior to a remaining portion of the mold assembly (16, 18) contacting remaining portions of the liquid such that said gas expels from between said substrate and said mold assembly and said liquid fills a volume defined between said mold assembly and substrate.

2. The method as recited in claim 1 wherein the step of contacting (94) said sub-portion further comprises a step of contacting a center region of said liquid with said mold assembly (16, 18).

3. A method for expelling a gas positioned between a substrate and a mold assembly (16, 18), said substrate (12) and said mold assembly (16, 18) further having a liquid positioned (32) therebetween, said method comprising the steps of:
positioning (100) said mold assembly (16, 18) and said substrate (12) such that said mold assembly (16, 18) is spaced-apart from said substrate a distance, said mold assembly (16, 18) having a first and a second region (78, 81; 178, 181); and then
altering (104) a shape of said mold assembly (16, 18) by bowing said first region (78; 178) away from said substrate (12) such that said second region (81; 181) bows toward said substrate (12), said second region (81; 181) contacting a sub-portion of said liquid (32) prior to a remaining portion of the mold assembly (16, 18) contacting remaining portions of the liquid to expel said gas from between said substrate and said mold assembly (16, 18) such that said liquid fills a volume defined between said mold assembly and said substrate.

4. The method as recited in claim 1 or 3 wherein the step of altering (94; 104) said shape further comprises a step of creating a pressure differential between a first chamber (80; 180) defined between a portion of a chuck (28; 128) coupled to said mold assembly (16, 18) and said first region (78; 178) of said mold assembly (16, 18) and a second chamber (82; 182) defined between a portion of said chuck (28; 128) and said second region (81; 181) of said mold assembly (16, 18).

5. The method as recited in claim 1 or 3 wherein the step of altering (94; 104) said shape further comprises a step of subjecting a chamber defined between a portion of a chuck (28; 128) coupled to said mold assembly (16, 18) and said first region (78; 178) of said mold assembly to a vacuum.

6. The method as recited in claim 3 wherein the step of altering (104) said shape further comprises a step of contacting a center region of said liquid (32) with said mold assembly (16, 18).

7. The method as recited in claim 1 or 3 wherein a magnitude of time of contact between said mold assembly (16, 18) and said liquid (32) is selected to maximize a uniformity of a layer formed from said liquid.

8. The method as recited in claim 1 or 3 further comprising the step of impinging (96; 106) actinic energy upon said liquid to solidify the same.

9. The method as recited in claim 4, wherein:
the chuck (28; 128) has first and second opposed sides (58, 60; 158, 160), said first side including first and second spaced-apart recesses (64, 66; 164, 166) defining first and second spaced-apart support regions (68, 70; 168, 170), with said first support region (68; 168) cincturing said second support region (70; 170) and said first and second recesses (64, 66; 164, 166), and said second support region (70; 170) cincturing said second recess (66; 166), and a fluid channel (74; 174b) extending through said chuck (28; 128) to said first recess (64; 164);
the mold assembly (16, 18) is coupled to said first side (58; 154) of said chuck (28; 128), with a portion of said mold in superimposition with said first recess (64; 164) defining a first chamber (80; 180) and a portion of said mold in superimposition with said second recess (66; 166) defining a second chamber (82; 182); and
a pressure control system (54, 56, 76; 176) is coupled to said chuck to apply a vacuum pressure in said first chamber (80; 180) through said fluid channel to carry out said step of altering a shape of the mold assembly by bowing said first portion (78; 178) of said mold assembly (16, 18) towards said chuck such that said second portion (81; 181) of said mold assembly bows away from said chuck (28; 128).

10. The method as recited in claim 9 wherein said first recess (64; 164) further comprises a plurality of spaced-apart pins extending therefrom.

11. The method as recited in claim 9 wherein a portion of said chuck (28; 128) in superimposition with said second recess (66; 166) is transparent to radiation having a predetermined wavelength.

12. The method as recited in claim 9 wherein a compliant sealing positioned adjacent said second support region (70; 170) is provided to isolate said first chamber (80; 180) from said second chamber (82; 182).

13. The method as recited in claim 9 wherein each of said first and second support regions (68, 70; 168, 170) has a support surface associated therewith, facing away from said second surface, with said support surface being formed from a material adapted to conform to a profile of said mold assembly (16, 18).

14. The method as recited in claim 9 further including an additional fluid channel (174b) extending through said chuck (128) to said second recess (166) to place said pressure control system in fluid communication with said second chamber (182).

15. The method as recited in claim 9 wherein said mold assembly (16, 18) further comprises a plurality of protrusions and recessions.

16. The method as recited in claim 1 wherein said step of contacting a sub-portion of said liquid with said second region (81; 181) of said mold assembly is achieved by decreasing a distance (d1) between the mold assembly (16, 18) and the substrate (12).

## Patentansprüche

1. Verfahren zum Ausstoßen von zwischen einem Substrat (12) und einer Formeinheit (16, 18) positioniertem Gas, wobei das Substrat und die Formeinheit weiter eine dazwischen positionierte Flüssigkeit (32) aufweisen, das Verfahren umfassend:
Positionieren (90) der Formeinheit (16, 18) und des Substrats (12), sodass die Formeinheit nahe dem Substrat ist, wobei die Formeinheit (16, 18) einen ersten Bereich (78; 178) und einen zweiten Bereich (81; 181) aufweist;
Verändern (92) einer Gestalt der Formeinheit (16, 18) durch Wölben des ersten Bereiches (78; 178) weg vom Substrat, sodass sich der zweite Bereich (81; 181) zum Substrat hin wölbt, um einen Zwischenraum zu verkleinern, der zwischen dem zweiten Bereich (81; 181) der Formeinheit (16, 18) und dem Substrat (12) definiert ist; und
Berühren (94) eines Teils der Flüssigkeit mit dem zweiten Bereich (81; 181) der Formeinheit (16; 18) vor dem Berühren eines restlichen Teils der Formeinheit (16, 18) von restlichen Teilen der Flüssigkeit, sodass das Gas von zwischen dem Substrat und der Formeinheit ausgestoßen wird und die Flüssigkeit ein Volumen ausfüllt, das zwischen der Formeinheit und dem Substrat definiert ist.

2. Verfahren nach Anspruch 1, wobei der Schritt des Berührens (94) des Teils weiter einen Schritt des Berührens eines Mittenbereiches der Flüssigkeit mit der Formeinheit (16, 18) umfasst.

3. Verfahren zum Ausstoßen von zwischen einem Substrat und einer Formeinheit (16, 18) positioniertem Gas, wobei das Substrat (12) und die Formeinheit weiter eine dazwischen positionierte Flüssigkeit (32) aufweisen, das Verfahren umfassend:
Positionieren (90) der Formeinheit (16, 18) und des Substrats (12), sodass die Formeinheit (16, 18) von dem Substrat um einen Abstand beabstandet ist, wobei die Formeinheit (16, 18) einen ersten Bereich (78; 178) und einen zweiten Bereich (81; 181) aufweist; und dann
Verändern (104) einer Gestalt der Formeinheit (16, 18) durch Wölben des ersten Bereiches (78; 178) weg vom Substrat (12), sodass sich der zweite Bereich (81; 181) zum Substrat (12) hin wölbt, wobei der zweite Bereich (81; 181) einen UnterTeil der Flüssigkeit (32) berührt, bevor ein restlicher Teil der Formeinheit (16, 18) restliche Teile der Flüssigkeit berührt, um das Gas von zwischen dem Substrat und der Formeinheit auszustoßen, sodass die Flüssigkeit ein Volumen ausfüllt, das zwischen der Formeinheit und dem Substrat definiert ist.

4. Verfahren nach Anspruch 1 oder 3, wobei der Schritt des Veränderns (94; 104) der Gestalt weiter einen Schritt des Erzeugens eines Druckunterschieds zwischen einer ersten Kammer (80; 180), die zwischen einem Teil einer Spannvorrichtung (28; 128), die mit der Formeinheit gekoppelt ist, und dem ersten Bereich (78; 178) der Formeinheit (16, 18) definiert ist, und einer zweiten Kammer (82; 182), die zwischen einem Teil der Spannvorrichtung (28; 128) und dem zweiten Bereich (81; 181) der Formeinheit (16, 18) definiert ist, umfasst.

5. Verfahren nach Anspruch 1 oder 3, wobei der Schritt des Veränderns (94; 104) der Gestalt weiter einen Schritt umfasst, eine Kammer, die zwischen einem Teil einer Spannvorrichtung (28; 128), die mit der Formeinheit (16, 18) gekoppelt ist, und dem ersten Bereich (78; 178) der Formeinheit definiert ist, einem Vakuum auszusetzen.

6. Verfahren nach Anspruch 3, wobei der Schritt des Veränderns (104) der Gestalt weiter einen Schritt umfasst, einen Mittenbereich der Flüssigkeit (32) mit der Formeinheit (16, 18) zu berühren.

7. Verfahren nach Anspruch 1 oder 3, wobei der Betrag der Zeit des Kontakts zwischen der Formeinheit (16, 18) und der Flüssigkeit (32) ausgewählt ist, um eine Gleichmäßigkeit einer Schicht, die aus der Flüssigkeit gebildet wird, zu maximieren.

8. Verfahren nach Anspruch 1 oder 3, weiter umfassend den Schritt des Beaufschlagens (96; 106) der Flüssigkeit mit aktinischer Energie, um selbige zu verfestigen.

9. Verfahren nach Anspruch 4, wobei:
die Spannvorrichtung (28; 128) erste und zweite gegenüberliegende Seiten (58, 60; 158, 160) aufweist, wobei die erste Seite erste und zweite beabstandete Einbuchtungen (64, 66; 164, 166) beinhaltet, die erste und zweite beabstandete Trägerbereiche (68, 70; 168, 170) definieren, wobei der erste Trägerbereich (68; 168) den zweiten Trägerbereich (70; 170) und die ersten und zweiten Einbuchtungen (64, 66; 164, 166) umgürtet, und der zweite Trägerbereich (70; 170) die zweite Einbuchtung (66; 166) umgürtet, und ein Flüssigkeitskanal (74; 174b) sich durch die Spannvorrichtung (28; 128) zur ersten Einbuchtung (64; 164) hin erstreckt;
die Formeinheit (16, 18) mit der ersten Seite (58; 154) der Spannvorrichtung (28; 128) gekoppelt ist, wobei ein Teil der Form in Überlagerung mit der ersten Einbuchtung (64; 164) eine erste Kammer (80; 180) definiert und ein Teil der Form in Überlagerung mit der zweiten Einbuchtung (66; 166) eine zweite Kammer (82; 182) definiert; und
ein Drucksteuerungssystem (54, 56, 76; 176) mit der Spannvorrichtung gekoppelt ist, um einen Vakuumdruck auf die erste Kammer (80; 180) durch den Flüssigkeitskanal aufzubringen, um der Schritt des Veränderns einer Gestalt der Formeinheit durch Wölben des ersten Teils (78; 178) der Formeinheit (16, 18) in Richtung der Spannvorrichtung durchzuführen, sodass sich der zweite Teil (81; 181) der Formeinheit von der Spannvorrichtung (28; 128) weg wölbt.

10. Verfahren nach Anspruch 9, wobei die erste Einbuchtung (64; 164) weiter eine Mehrzahl von beabstandeten Stiften umfasst, die sich daraus erstrecken.

11. Verfahren nach Anspruch 9, wobei ein Teil der Spannvorrichtung (28; 128) in Überlagerung mit der zweiten Einbuchtung (66; 166) für Strahlung einer vorbestimmten Wellenlänge transparent ist.

12. Verfahren nach Anspruch 9, wobei eine nachgiebige Dichtung bereitgestellt ist, die anschließend an den zweiten Trägerbereich (70; 170) positioniert ist, um die erste Kammer (80; 180) von der zweiten Kammer (82; 182) zu isolieren.

13. Verfahren nach Anspruch 9, wobei jeder der ersten und zweiten Trägerbereiche (68, 70; 168, 170) eine damit verbundene Trägeroberfläche aufweist, die weg von der zweiten Oberfläche zeigt, wobei die Trägeroberfläche aus einem Material gebildet ist, das angepasst ist, um einem Profil der Formeinheit (16, 18) zu entsprechen.

14. Verfahren nach Anspruch 9, weiter beinhaltend einen zusätzlichen Flüssigkeitskanal (174b), der sich durch die Spannvorrichtung (128) zur zweiten Einbuchtung (166) hin erstreckt, um das Drucksteuerungssystem in Fluidverbindung mit der zweiten Kammer (182) zu platzieren.

15. Verfahren nach Anspruch 9, wobei die Formeinheit (16, 18) weiter eine Mehrzahl von Vorsprünge und Vertiefungen umfasst.

16. Verfahren nach Anspruch 1, wobei der Schritt des Berührens eines Teils der Flüssigkeit mit dem zweiten Bereich (81; 181) der Formeinheit durch verringern eines Abstandes (d1) zwischen der Formeinheit (16, 18) und dem Substrat (12) erreicht wird.

## Revendications

1. Procédé pour expulser un gaz placé entre un substrat (12) et un ensemble formant moule (16, 18), ledit substrat et ledit ensemble formant moule ayant en outre un liquide (32) placé entre eux, ledit procédé comprenant les étapes consistant à :
positionner (90) ledit ensemble formant moule (16, 18) et ledit substrat (12) de telle façon que ledit ensemble formant moule se trouve à proximité dudit substrat, ledit ensemble formant moule (16, 18) ayant une première région (78 ; 178) et une seconde région (81 ; 181) ;
modifier (92) une forme dudit ensemble formant moule (16, 18) en cintrant ladite première région (78 ; 178) en éloignement dudit substrat de telle façon que ladite seconde région (81 ; 181) est cintrée vers ledit substrat pour réduire un intervalle défini entre ladite seconde région (81 ; 181) dudit ensemble formant moule (16, 18) et ledit substrat (12) ; et
mettre en contact (94) une sous-portion dudit liquide avec ladite seconde région (81 ; 181) dudit ensemble formant moule (16 ; 18) avant qu'une portion restante de l'ensemble formant moule (16, 18) vienne en contact avec des portions restantes du liquide, de telle façon que ledit gaz est expulsé depuis entre ledit substrat et ledit ensemble formant moule, et ledit liquide remplit un volume défini entre ledit ensemble formant moule et ledit substrat.

2. Procédé selon la revendication 1, dans lequel l'étape de mise en contact (94) de ladite sous-portion comprend encore une étape consistant à mettre en contact une région centrale dudit liquide avec ledit ensemble formant moule (16, 18).

3. Procédé pour expulser un gaz placé entre un substrat et un ensemble formant moule (16, 18), ledit substrat (12) et ledit ensemble formant moule (16, 18) ayant en outre un liquide (32) placé entre eux, ledit procédé comprenant les étapes consistant à :
positionner (100) ledit ensemble formant moule (16, 18) et ledit substrat (12) de telle façon que ledit ensemble formant moule (16, 18) est écarté dudit substrat sur une distance, ledit ensemble formant moule (16, 18) ayant une première région et une seconde région (78, 81 ; 178, 181) ; et ensuite
modifier (104) une forme dudit ensemble formant moule (16, 18) en cintrant ladite première région (78 ; 178) en éloignement dudit substrat (12) de telle façon que ladite seconde région (81 ; 181) est cintrée vers ledit substrat (12), ladite seconde région (81 ; 181) venant en contact avec une sous-portion dudit liquide (32) avant qu'une portion restante de l'ensemble formant moule (16, 18) vienne en contact avec des portions restantes du liquide pour expulser ledit gaz depuis entre ledit substrat et ledit ensemble formant moule (16, 18), de telle façon que ledit liquide remplit un volume défini entre ledit ensemble formant moule et ledit substrat.

4. Procédé selon la revendication 1 ou 3, dans lequel l'étape consistant à modifier (94 ; 104) ladite forme comprend en outre une étape consistant à créer une différentielle de pression entre une première chambre (80 ; 180) définie entre une portion d'un mandrin (28 ; 128) couplé audit ensemble formant moule (16, 18) et ladite première région (78 ; 178) dudit ensemble formant moule (16, 18) et une seconde chambre (82 ; 182) définie entre une portion dudit mandrin (28 ; 128) et ladite seconde région (81 ; 181) dudit ensemble formant moule (16, 18).

5. Procédé selon la revendication 1 ou 3, dans lequel l'étape consistant à modifier (94 ; 104) ladite forme comprend encore une étape consistant à soumettre une chambre définie entre une portion d'un mandrin (28 ; 128) couplé audit ensemble formant moule (16, 18) et ladite première région (78 ; 178) dudit ensemble formant moule à un vide.

6. Procédé selon la revendication 3, dans lequel l'étape consistant à modifier (104) ladite forme comprend encore une étape consistant à mettre en contact une région centrale dudit liquide (32) avec ledit ensemble formant moule (16, 18).

7. Procédé selon la revendication 1 ou 3, dans lequel une durée du temps de contact entre ledit ensemble formant moule (16, 18) et ledit liquide (32) est choisie pour maximiser une uniformité d'une couche formée à partir dudit liquide.

8. Procédé selon la revendication 1 ou 3, comprenant encore l'étape consistant à faire tomber (96 ; 106) de l'énergie actinique sur ledit liquide pour solidifier celui-ci.

9. Procédé selon la revendication 4, dans lequel :
le mandrin (28 ; 128) comprend un premier et un second côté opposés (58, 60 ; 158, 160), ledit premier côté incluant un premier et un second évidement espacés (64, 66 ; 164, 166) définissant une première et une seconde région de support espacées (68, 70 ; 168, 170), avec ladite première région de support (68 ; 168) ceinturant ladite seconde région de support (70 ; 170), et ledit premier et ledit second évidement (64, 66 ; 164, 166), et ladite seconde région de support (70 ; 170) ceinturant ledit second évidement (66 ; 166), et un canal à fluide (74 ; 174b) s'étendant à travers ledit mandrin (28 ; 128) jusqu'audit premier évidement (64 ; 164) ;
l'ensemble formant moule (16, 18) est couplé audit premier côté (58 ; 154) dudit mandrin (28 ; 128), avec une portion dudit moule en superposition avec ledit premier évidement (64 ; 164) définissant une première chambre (80 ; 180), et une portion dudit moule en superposition avec ledit second évidement (66 ; 166) définissant une seconde chambre (82 ; 182) ; et
un système de commande de pression (54, 56, 76 ; 176) est couplé audit mandrin pour appliquer une pression de vide dans ladite première chambre (80 ; 180) via ledit canal à fluide pour effectuer ladite étape de modification d'une forme de l'ensemble formant moule en cintrant ladite première portion (78 ; 178) dudit ensemble formant moule (16, 18) vers ledit mandrin, de sorte que ladite seconde portion (81 ; 181) dudit ensemble formant moule est cintrée en éloignement dudit mandrin (28 ; 128).

10. Procédé selon la revendication 9, dans lequel ledit premier évidement (64 ; 164) comprend encore une pluralité de tiges espacées s'étendant de lui-même.

11. Procédé selon la revendication 9, dans lequel une portion dudit mandrin (28 ; 128) en superposition avec ledit second évidement (66 ; 166) est transparente au rayonnement ayant une longueur d'onde prédéterminée.

12. Procédé selon la revendication 9, dans lequel un moyen d'étanchement souple positionné adjacent à ladite seconde région de support (70 ; 170) est prévu pour isoler ladite première chambre (80 ; 180) vis-à-vis de ladite seconde chambre (82 ; 182).

13. Procédé selon la revendication 9, dans lequel chacune de ladite première et de ladite seconde région de support (68, 70 ; 168, 170) comporte une surface du support associée à elle-même, détournée de ladite seconde surface, ladite surface de support étant formée d'un matériau adapté à se conformer à un profil dudit ensemble formant moule (16, 18).

14. Procédé selon la revendication 9, incluant en outre un canal à fluide additionnel (174b) s'étendant à travers ledit mandrin (128) vers ledit second évidement (166) pour mettre ledit système de commande de pression en communication fluidique avec ladite seconde chambre (182).

15. Procédé selon la revendication 9, dans lequel ledit ensemble formant moule (16, 18) comprend en outre une pluralité de projections et de creux.

16. Procédé selon la revendication 1, dans lequel ladite étape de mise en contact d'une sous-portion dudit liquide avec ladite seconde région (81 ; 181) dudit ensemble formant moule est exécutée en diminuant une distance (d1) entre l'ensemble formant moule (16, 18) et le substrat (12).
